# EUROPEAN PATENT SPECIFICATION

(11) **EP 4 369 604 B1**
(45) Date of publication and mention of the grant of the patent: **25.02.2026**
(21) Application number: 22315276.0
(22) Date of filing: 10.11.2022
(51) Int. Cl.: H03K 17/0812, H02M 1/38, H03K 17/61, H03K 17/691, H03K 17/785, H03K 17/795

(54) **OVERLAPPING PROTECTION USING GATE CURRENT MIRROR IN A POWER CONVERTER**
ÜBERLAPPENDER SCHUTZ MIT GATE-STROMSPIEGEL IN EINEM STROMWANDLER
PROTECTION CONTRE LE CHEVAUCHEMENT UTILISANT UN MIROIR DE COURANT DE GRILLE DANS UN CONVERTISSEUR DE PUISSANCE

(43) Date of publication of application: 15.05.2024
(73) Proprietor: MITSUBISHI ELECTRIC R&D CENTRE EUROPE BV, 1119 NS CHIPHOL RIJK AMSTERDAM (NL); MITSUBISHI ELECTRIC CORPORATION, Chiyoda-ku Tokyo 100-8310 (JP)
(72) Inventor: Le Leslé, Johan, 35708 RENNES CEDEX 7 (FR); Lefevre, Guillaume, 35708 RENNES CEDEX 7 (FR)
(74) Representative: Plasseraud IP

(56) References cited:
- US-A- 5 099 138
- US-A1- 2010 231 269
- US-A1- 2014 292 392
- US-A1- 2018 175 773
- KAZUFUMI YUASA ET AL: "Ultra high speed short circuit protection for IGBT with gate charge sensing", POWER SEMICONDUCTOR DEVICES&IC'S (ISPSD), 2010 22ND INTERNATIONAL SYMPOSIUM ON, IEEE, PISCATAWAY, NJ, USA, 6 June 2010 (2010-06-06), pages 37 - 40, XP031729179, ISBN: 978-1-4244-7718-0

## Description

### Field of the invention

The present disclosure concerns power converters comprising at least one switching half-bridge and more precisely concerns a protection against overlapping during switching transition periods of switches of said switching half-bridge.

### Background

In a power converter composed of at least one half-bridge, the switches are controlled in a complementary way to provide conducting to blocking and blocking to conducting transitions. Between these transitions, dead times where both switches are OFF are necessary. The main reason of the dead-times is the risk of overlapping of the control voltages due to multiple factors including propagation delay, mismatch between the turn-on and turn-off delay times, drift of the threshold voltage with temperature, leading to shoot-through current which could damage the devices.

In existing converters, different methods to ensure non-overlapped control signals applied to a half-bridge.

A first method is to use an off-the-shelf dedicated half-bridge gate driver IC having overlapping protection. Generally, such devices include logical conditioning circuits avoiding the overlapping of the output signals controlling the gate of the half-bridge power device, even if the signals coming from the controller are overlapped. The implemented signal conditioning depends on the manufacturer and cannot be known by external users. For example, the gate driver ICs known under reference Si8273 from the company Silicon Labs are proposing an overlapping protection circuit detecting when both input levels are high and forcing one of the outputs to the GND avoiding any short-circuit on the power side.

A second method is related to gate driver ICs without overlapping protection and require to properly sequence the control signals fed to the gate drivers to avoid any issue. Therefore, a sufficient dead-time must be settled.

As said above, a fast and precise control of the two switches of a half-bridge is mandatory in a power converter. Nevertheless, Wide Band Gap devices such as SiC or GaN have fast switching capabilities which leads to an increase in switching frequency, therefore increasing the constraints on the control part.

The commonly implemented half-bridge configuration requires proper control timing to avoid cross-conduction and shoot-through current which can lead to significant additional losses or even the destruction of the semiconductors.

However, false control signals can be applied to gate electrode leading to cross-conduction. The reasons to such a situation can be several, e.g. control error pulling up one of the gate driver outputs at a wrong time, faulty gate driver IC blocked at a high state, or false control signal due EMI issue. Therefore, an overlapping detection/protection can prevents short-circuit due to controller error or faulty gate driver.

Document US US5099138A1 provides a principle of protection system where signal issued from the gate of one switch of a half bridge is used to confirm a power on signal of the other switch of said half bridge.

### Summary of the invention

In view of such situation, the present disclosure proposes a simple protection system using a gate current sensing technique based on current to detect such false control signals and proposes a circuitry avoiding short-circuit of the half-bridge in such cases.

The proposed circuitry is based on current mirror technique. A current mirror circuit allows to sense the gate current of one of the switches during its turn-on and, in case the other of the switches is already on, a protective circuit may switch said other switch off.

The mirrored current is then processed and transferred to the opposite gate driver thought an insulation barrier. A conditioning and/or buffer circuit allows to detect if a positive gate current is sensed while the second gate driver voltage is already high. Therefore, a protection can be implemented with a proper dedicated logic.

In view of the above, the present disclosure proposes a gate drivers circuit, for a half-bridge of a converter where a first switching device, having a first gate, and a second switching device, having a second gate, are controlled in a complementary way respectively through a first gate driver buffer and a second gate driver buffer, by a controller providing gate pull up and gate pull down pulse signals to the first and second gate drivers buffers, said gate drivers circuit comprising an overlapping protection circuit comprising:
- on a source branch of said first gate driver buffer a first gate current mirroring circuit to provide a first detection signal upon turning on of said first gate driver buffer and a first detection circuit for processing and transferring said first detection signal to a second protection circuit of said second gate buffer configured to turn off said second switching device upon occurrence of said first detection signal;
- on a source branch of said second gate driver buffer a second gate current mirroring circuit to provide a second detection signal upon turning on of said second gate driver buffer and a second detection circuit for processing and transferring said first detection signal to a first protection circuit of said first gate buffer configured to turn off said first switching device upon occurrence of said second detection signal.

Such a gate driver circuit protects the half-bridge through a fast protection circuit against overlapping.

To provide insulation barriers between up and down circuits, said first detection circuit may be connected to said first gate mirroring circuit through a first insulation barrier and said second detection circuit may be connected to said second gate mirroring circuit through a second insulation barrier. In a realization mode, such insulation barrier is a current transformer.

To improve the signals and avoid false detections, said first and second detection circuits may each comprise a conditioning circuit to filter the first and second detection signals.

The present disclosure also concerns gate drivers circuit, for a half-bridge of a converter where said first and second detection circuits each comprise a trigger circuit and false detection protection circuit, said false detection protection circuit of one of said first and second detection circuits enabling the detection of an overlapping error only when a detection signal issues when a positive driver command output (vo+) of a pre-driver (10a, 10b) of the other of said first and second detection circuits is on.

In such case, said first and second detection circuits may each comprise a latch circuit to latch the detected overlapping error, transfer the detected overlapping error to the controller and trigger the protection circuit.

This provides both protection of the half-bridge and information of the defect at the controller level.

Each of said first and second protection circuits may be composed of a controllable switch pulling down a gate electrode of a corresponding switching device. The controllable switch may be made of a diode and a MOSFET.

The controller may comprise reset outputs for resetting the detection circuits in order to restart the conversion.

Said reset outputs may be connected through insulation devices to reset inputs of said latch circuits.

The gate drivers buffers associated to the current mirroring circuits may be driven by pre-driver circuits transferring control signals from the controller to the gate drivers buffers and providing a galvanic insulation between said controller and said gate drivers buffers.

The present disclosure concerns also a half-bridge converter comprising a gate drivers circuit as depicted above.

### Brief description of the drawings

A detailed description of exemplary embodiments of the invention will be discussed hereunder in reference to the attached drawings where:
Figure 1: is a schematic view of a traditional half-bridge in a converter;
Figure 2: is a schematic view sowing blocks of a half-bridge command circuit comprising a detection/protection circuit according to the present disclosure;
Figure 3: is a detail of an upper detection/protection circuit of the present disclosure;
Figure 4: is a schematic of a complete half-bridge command circuit comprising the detection/protection circuit of the present disclosure;
Figure 5: shows a switching waveform for overlapped control signals without overlapping protection circuit;
Figure 6: shows a switching waveform for overlapped control signals with overlapping protection circuit.

### Detailed description of embodiments of the invention

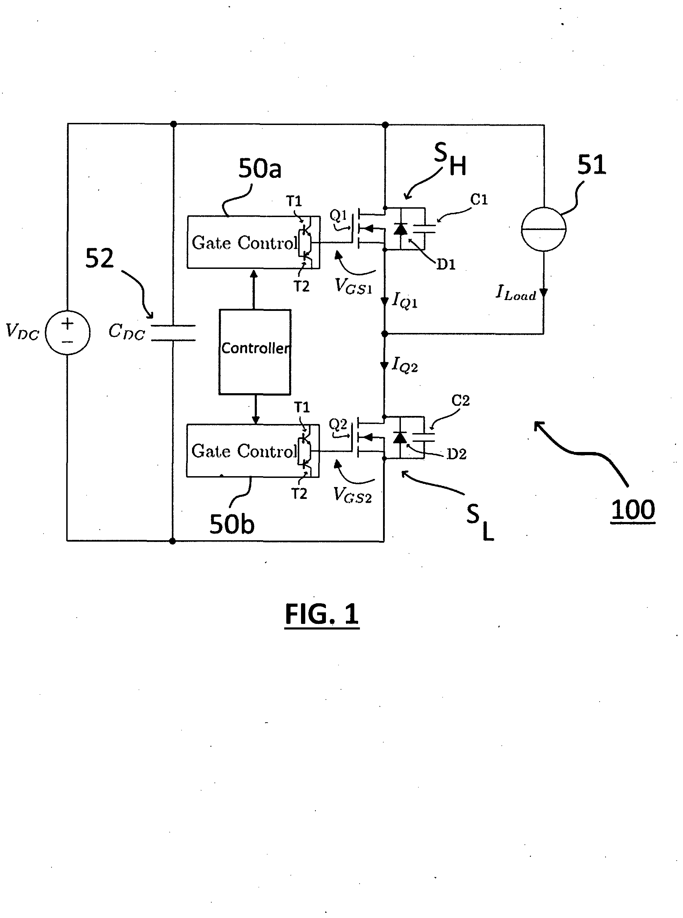

Figure 1 is a schematic view of a half-bridge in a converter with upper leg switch S_{H} and lower leg switch S_{L} the upper leg switch comprises a transistor Q1 which is in the present case a MOSFET represented with its body diodes D1 and its parasitic output capacitor C1 while the lower leg switch comprises transistor Q2represented with its body diode D2 and parasitic output capacitor C2. The reverse diodes D1 and D2 may be an additional component.

In such figure, MOSFET devices are considered in the switching cell, the switch symbol includes the intrinsic body-diode and output capacitor COSS, the load 51 is connected between the middle point of the switching cell and the high potential of the DC voltage source, the load current is considered positive, meaning the current goes from the positive DC bus to the middle node of the switching cell and the load current is considered constant during the transition time scale.

The switches S_{H} and S_{L} are controller through gate control circuits 50a for the upper leg switch and 50b for the lower leg switch and a capacitor 52 on the DC side filters the HF signals created by the switching sequences. The gate control circuits 50a, 50b comprise push-pull output transistors as known in the art.

Starting from such basic schematics, the present disclosure concerns a detection/protection circuit to protect a half-bridge of a converter against overlapping and prevent short-circuit due to controller error or faulty gate driver.

Such circuit aims at detecting overlapping of gate control signals or false turn-on of the power device because of a faulty gate driver. Both would induce short-circuit in the power stage. The overlapping protection can be implemented in any kind of voltage source converter, where short-circuit must be absolutely avoided.

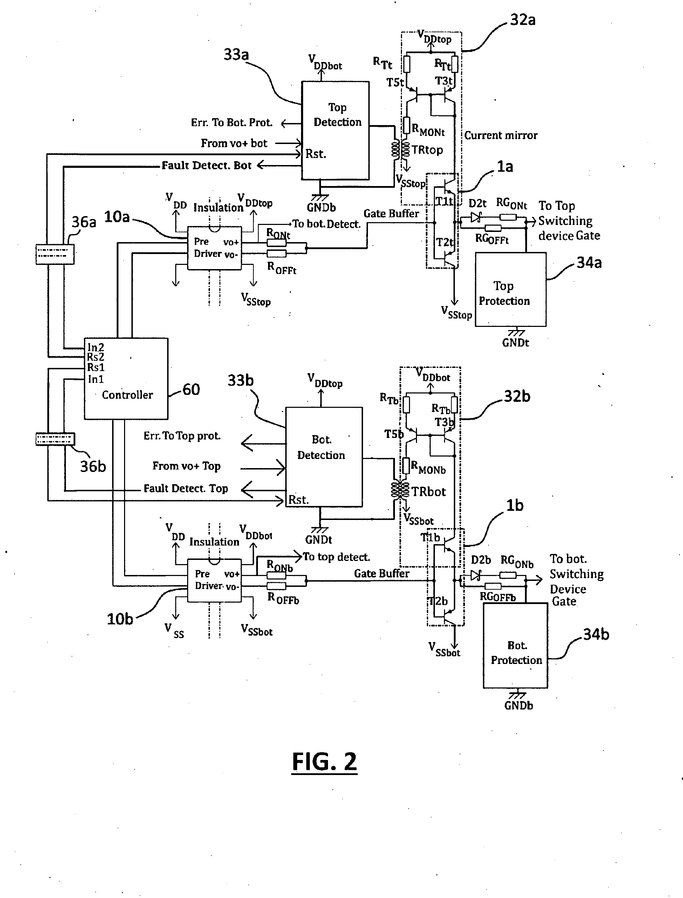

Figure 2 provides a schematic view with functional block of the circuit of the present disclosure. The circuits start with upper current mirror circuit 32a and lower current circuit 32b. The circuit comprises a top protection circuit 34a and a bottom protection circuit 34b , pre-drivers 10a, 10b which receive command from a controller 60 and provide a galvanic insulation between such controller and the top and bottom driver circuits. The circuit also comprise top protection circuit 34a connected to the bottom detection circuit 33b, bottom protection circuit 34b connected to the top detection circuit 33a and galvanic insulation circuits 36a, 36b which transmit error signals from the detection circuits to the controllers through insulation barriers such as photocouplers or other insulation devices. The galvanic insulations between the controller, top gate buffer circuit and bottom gate buffer circuit are needed since those parts of the half-bridge converter are powered through different voltage sources.

The galvanic insulations, also called insulation barriers, may be done with optocouplers, current transformers or voltage transformers.

In the figures it should be noted that elements driving the second switching device S_{L} are called bottom elements also called "Bot." such as "Bot. Detection" or "Bot. Detect.", "Bot. Protection" or "Bot. Prot.", Elements driving the first switching device S_{H} are called top elements and have the prefix "Top" such as "Top Protection" or "Top Prot.", "Top Detection" or "Top Detect." .

Top circuit ground is labelled GNDt, bottom circuit ground is labelled GNDb, Top circuit VDD is labelled V_{DDtop}, Bottom circuit VDD is labelled V_{DDbot}, Top circuit VSS is labelled V_{SStop}, Bottom circuit VSS is labelled V_{SSbot}.

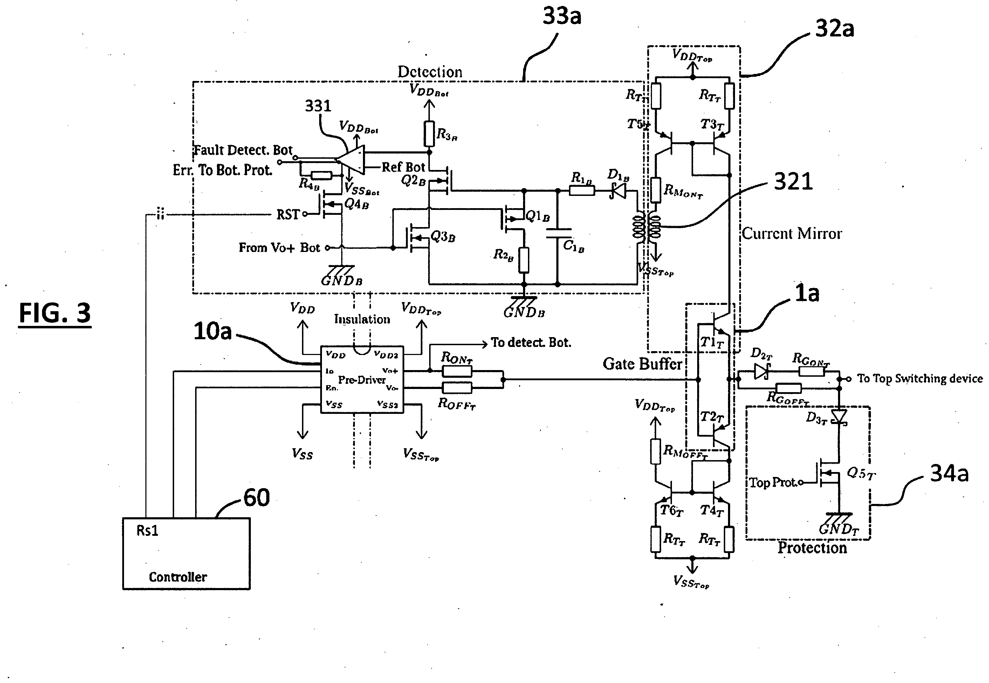

Both top circuit and bottom circuit are built on the same design and Figure 3 provides a more detailed view of the upper part of the half-bridge command circuit where the upper current mirror circuit 32a is connected to the top detection circuit 33a through a current transformer 321. Such current transformer may be replaced by another type of insulation barrier such as optocouplers, current transformers or voltage transformers.

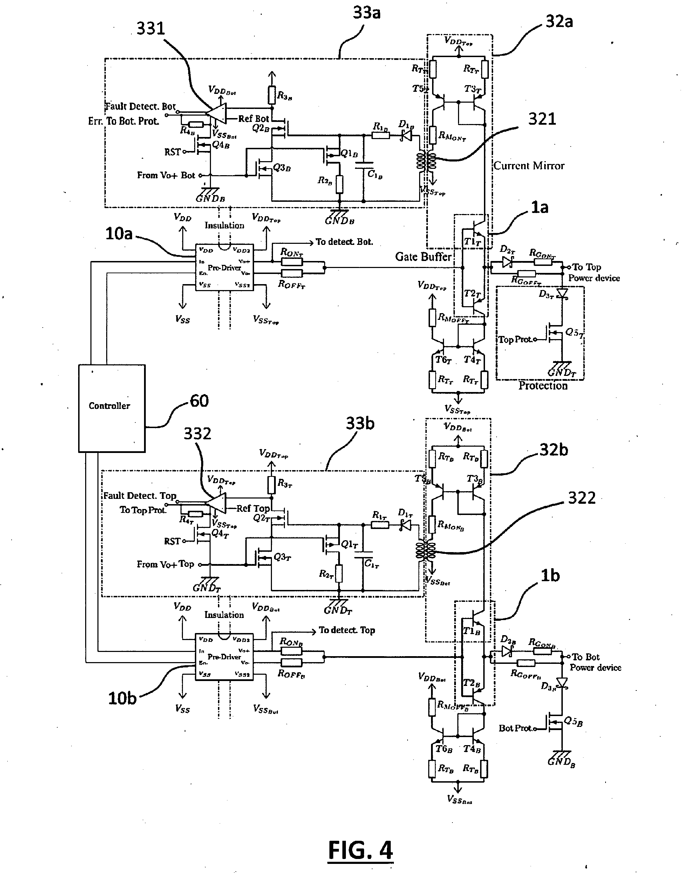

The current mirror circuit made of transistors T5_{T} and T3_{T} resistors RT_{T} and R_{MonT} is used to copy the gate current sourced by the gate buffer to the gate driver through the insulation barrier here provided by the transformer 321. The detection circuit is composed of several sub-function, a conditioning circuit C1_{B}, D1_{B} and R1_{B} which is conditioning the signal coming from the current transformer 321 and, in case of an overlapping detection, the transistor Q2_{B} is triggering the comparator 331 which receives on its negative input a reference voltage "Ref Bot." which sets the system response time. In this design, the MOSFETs Q1_{B} and Q3_{B} are used to avoid false triggering of the protection. The comparator is necessary to latch the detected error, transfer the detection to the controller with the "FaultDetect. Bot" signal and trigger the protection circuit of the bottom gate buffer composed of a controllable switch made here of diode D3_{B} and MOSFET Q5_{B} pulling down the base of the gate buffer 1b shown in figure 4 and the gate electrode of the bottom power device. The controllable switch function can be implemented with some other known controllable switch components such as JFET, BJT, HEMT for example.

The bottom circuit is identical with, C1_{T}, D1_{T} and R1_{T} which are conditioning the signal coming from the current transformer 322, which may also be replaced by another type of insulation barrier such as optocouplers or voltage transformers. In case of an overlapping detection, the transistor Q2_{T} is triggering the comparator 332 which receives on its negative input the reference voltage "Ref Top". The MOSFETs Q1_{T} and Q3_{T} are used to avoid false triggering of the protection. The comparator is necessary to latch the detected error, transfer the detection to the controller with the "Fault Detect. Bot" signal and trigger the protection circuit of the bottom gate buffer with a controllable switch made here of diode D3_{B} and MOSFET Q5_{T} pulling down the base of the gate buffer 1a shown in figure 4 and the gate electrode of the top power device.

To summarize, the gate driver circuit of the half-bridge of a converter 100 where a first switching device S_{H}, having a first gate, and a second switching device S_{L}, having a second gate, are controlled independently and in a complementary way respectively through a first gate driver buffer 1a and a second gate driver buffer 1b, by a controller 60 providing gate pull up and gate pull down pulse signals to the first and second gate drivers buffers comprises an overlapping protection circuit comprising:
- on a source branch of said first gate driver buffer 1a a first gate current mirroring circuit 32a to provide a first detection signal upon turning on of said first gate driver buffer and a first detection circuit 33a for processing and transferring said first detection signal to a second protection circuit 34b of said second gate buffer 1b configured to turn off said second switching device S_{L} upon occurrence of said first detection signal;
- on a source branch of said second gate driver buffer 1b a second gate current mirroring circuit 32b to provide a second detection signal upon turning on of said second gate driver buffer and a second detection circuit 33b for processing and transferring said first detection signal to a first protection circuit 34a of said first gate buffer 1a configured to turn off said first switching device S_{H} upon occurrence of said second detection signal.

As said before insulation is needed between the detection circuits and the gate mirror circuits of a gate buffer since the detection circuit connected to a gate mirror circuit is referenced to the voltages of the other gate buffer in order to trigger the protection of this other gate buffer. In consequence the first detection circuit 33a, e.g. top detection circuit, is connected to the first gate mirroring circuit 32a, e.g. top gate mirroring circuit, through a first current transformer 321 providing a first insulation barrier and the second detection circuit 33b, e.g. bottom detection circuit, is connected to said second gate mirroring circuit 32b, e.g. bottom gate mirroring circuit, through a second current transformer 322 providing a second insulation barrier.

The trigger circuits Q2_{B}, Q2_{T} of the first and second detection circuits each comprise a false detection protection circuit Q1_{B}, Q1_{T}, Q3_{B}, Q3_{T} enabling the detection of an overlapping error only when a detection signal issues when an opposite pre-driver 10a, 10b positive driver command output "vo+" is on.

The latch circuits with comparators 331, 332 allow to latch the detected overlapping error, transfer the detected overlapping error "Fault Detect." to the controller and trigger the protection circuit 34a, 34b of the opposed gate through sending respectively the error signal "Err. To Bot. Prot." or the error signal "Err. To Top Prot.". A reset input of the comparator may be activated by the controller having Rs1, Rs2 outputs through the MOSFET transistors Q4_{B}, Q4_{T} of the top and bottom detection circuits 33a, 33b.

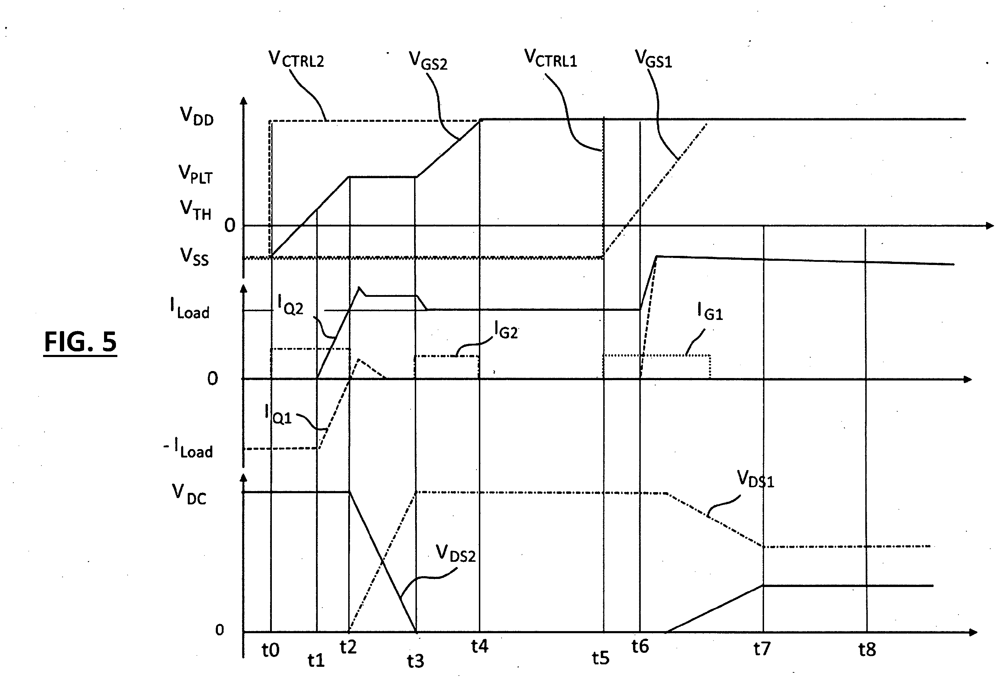

The impact of overlapped control signals is presented in figure 5 and depicted hereafter.

With reference to the notation in figure 1, the initial state corresponds to the freewheeling time, the load current is flowing through the top switch S_{H}. At the time t0, the control signal toggles from a negative to a positive value, the gate-source voltage V_{GS2} of Q2 of the switch S_{L} starts increasing. At t1 the gate-source voltage of the turning-on device S_{L} reaches the threshold value, thus the drain current, the current flowing through S_{L}, rises to the load current value. During the Miller plateau, from t2 to t3, the drain-source voltage V_{DS2} of Q2 drops from VDC to 0 while the drain-source voltage V_{DS1} of Q1 of the switch S_{H} rises accordingly. From t3 to t4, the gate-source voltage V_{GS2} of Q2 continue to rise but nothing changes in the power waveforms. At t5, a signal is sent to the gate of the second switch Q1, being relative to unproper operation due to one or several of the previously listed reasons. As soon as the gate voltage reaches the threshold, at t6, Q1 creates a short-circuit as it is conducting simultaneously with Q2. The current flowing through the switches rises upon a limit being set by the overall switching cell impedance. In fact, several kA can be reached possibly causing the destruction of the power device. After a certain amount of time, a slight decrease in the current is visible because of the self-heating of the power device which induces an increase in the on-state resistance. Both devices will share the DC bus voltage respectively to their transconductance.

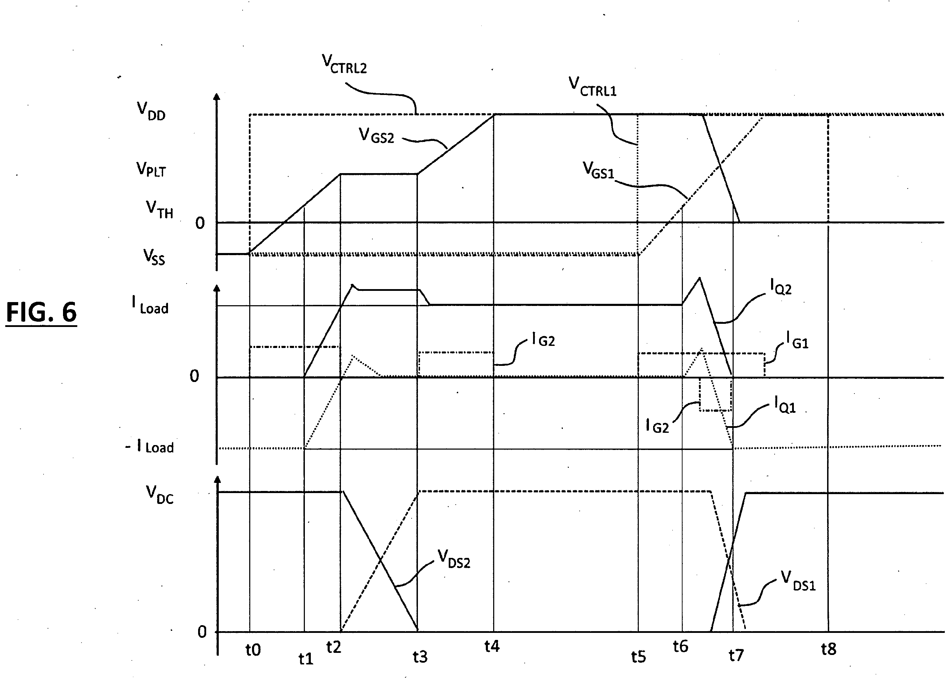

Then the influence of the proposed protection method is introduced, the updated waveforms are presented in figure 6. In the case that the gate driver is including the overlapping protection, from t0 to t4 the turn-on operation of Q2 remains unchanged as previously. The changes occur during the false turn-on of Q1. Indeed, at t5 the false signal is sent to the gate driver, the gate voltage starts rising, a positive gate current is sensed. At t6 the threshold is reached, thus the current starts to rise. However, after a slight delay the feedback of the sensed gate current on Q1 is sent to Q2's gate driver and forces the gate driver to turn-off. Therefore, the short circuit stops before a critical failure.

The hereabove description is based on a MOSFET application such as described in figure 1 but can be extended to any unipolar transistor such as JFET, IGFET, HEMT or bipolar transistors BJT or IGBT, with a change of name of the electrodes as known by the skilled artisan.

The present disclosure is not limited to the above description and in particular, the overlapping protection circuits described herein may be used in converters having more than one half-bridge, each half-bridge being provided with such a protection circuit for its top and bottom switch.

## Claims

1. - Gate drivers circuit, for a half-bridge of a converter (100) where a first switching device (S_{H}), having a first gate, and a second switching device (S_{L}), having a second gate, are controlled in a complementary way respectively through a first gate driver buffer (1a) and a second gate driver buffer (1b), by a controller (60) providing gate pull up and gate pull down pulse signals to the first and second gate drivers buffers, wherein said gate drivers circuit comprises an overlapping protection circuit comprising:
- on a source branch of said first gate driver buffer (1a) a first gate current mirroring circuit (32a) to provide a first detection signal upon turning on of said first gate driver buffer and a first detection circuit (33a) for processing and transferring said first detection signal to a second protection circuit (34b) of said second gate buffer (1b) configured to turn off said second switching device (S_{L}) upon occurrence of said first detection signal;
- on a source branch of said second gate driver buffer (1b) a second gate current mirroring circuit (32b) to provide a second detection signal upon turning on of said second gate driver buffer and a second detection circuit (33b) for processing and transferring said first detection signal to a first protection circuit (34a) of said first gate buffer (1a) configured to turn off said first switching device (S_{H}) upon occurrence of said second detection signal.

2. - Gate drivers circuit, for a half-bridge of a converter (100) according to claim 1 wherein said first detection circuit (33a) is connected to said first gate mirroring circuit (32a) through a first insulation barrier (321) and said second detection circuit (33b) is connected to said second gate mirroring circuit (32b) through a second insulation barrier (322).

3. - Gate drivers circuit, for a half-bridge of a converter (100) according to claim 2 wherein said first insulation barrier (321) and said second insulation barrier (322) are made with current transformers, optocouplers or voltage transformers.

4. - Gate drivers circuit, for a half-bridge of a converter (100) according to claims 1, 2 or 3 wherein said first and second detection circuits each comprise a conditioning circuit (D1, R1, C1) to filter the first and second detection signals.

5. - Gate drivers circuit, for a half-bridge of a converter (100) according to any one of the preceding claims wherein said first and second detection circuits each comprise a trigger circuit Q2_{B}, Q2_{T} and a false detection protection circuit (Q1_{B}, Q1_{T}, Q3_{B}, Q3_{T}), said false detection protection circuit of one of said first and second detection circuits enabling the detection of an overlapping error only when a detection signal issues when a positive driver command output (vo+) of a pre-driver (10a, 10b) of the other of said first and second detection circuits is on.

6. - Gate drivers circuit, for a half-bridge of a converter (100) according to claim 5 wherein said first and second detection circuits each comprise a latch circuit (331, 332) to latch the detected overlapping error, transfer the detected overlapping error (Err.) to the controller and trigger the protection circuit (34a, 34b) of their respective gate buffer.

7. - Gate drivers circuit, for a half-bridge of a converter (100) according to claim 6 wherein each of said first and second protection circuits (34a, 34b) are composed of at least one controllable switch (D3ₜ, D3_{b}, Q5ₜ, Q5_{b}) pulling down a gate electrode of a corresponding switching device (S_{H}, S_{L}).

8. - Gate drivers circuit, for a half-bridge of a converter (100) according to claim 7 wherein said at least one controllable switch is made of a diode and a MOSFET.

9. - Gate drivers circuit, for a half-bridge of a converter (100) according to claim 6 wherein the controller comprises reset outputs (Rs1, Rs2) for resetting the first and second detection circuits (33a, 33b).

10. - Gate drivers circuit, for a half-bridge of a converter (100) according to claims 6 and 9 wherein said reset outputs (Rs1, Rs2) are connected through insulation devices (36a, 36b) to reset inputs (Rst) of said latch circuits (331, 332).

11. - Gate drivers circuit according to any one of the preceding claims, wherein the gate driver buffers (1a, 1b) associated to the current mirroring circuits (32a, 32b) are driven by pre-driver circuits (10a, 10b) transferring control signals from the controller to the first and second gate drivers buffers and providing a galvanic insulation between said controller and said first and second gate driver buffers.

12. - Converter having at least a half-bridge comprising gate driver circuits according to any one of the preceding claims.

## Patentansprüche

1. Gate-Treiberschaltung für eine Halbbrücke eines Konverters (100), bei welchem eine erste Schaltvorrichtung (S_{H}), welche ein erstes Gate aufweist, und eine zweite Schaltvorrichtung (S_{L}), welche ein zweites Gate aufweist, jeweils über einen erstes Gate-Treiberpuffer (1a) und einen zweites Gate-Treiberpuffer (1b) durch eine Steuereinheit (60), welche dem ersten und dem zweiten Gate-Treiberpuffer Gate-Pull-Up- und Gate-Pull-Down-Pulssignale bereitstellt, auf eine komplementäre Weise gesteuert werden, wobei die Gate-Treiberschaltung eine überlappende Schutzschaltung umfasst, umfassend:
- an einer Quellenabzweigung des erstes Gate-Treiberpuffers (1a), eine erstes Gate-Stromspiegelungsschaltung (32a), um im Zuge eines Anschaltens des erstes Gate-Treiberpuffers ein erstes Detektionssignal bereitzustellen, und eine erste Detektionsschaltung (33a) zum Verarbeiten und Übertragen des ersten Detektionssignals an eine zweite Schutzschaltung (34b) des zweites Gate-Puffers (1b), welche dazu eingerichtet ist, im Zuge eines Auftretens des ersten Detektionssignals die zweite Schaltvorrichtung (S_{L}) auszuschalten;
- an einer Quellenabzweigung des zweites Gate-Treiberpuffers (1b), eine zweites Gate-Stromspiegelungsschaltung (32b), um im Zuge eines Anschaltens des zweites Gate-Treiberpuffers ein zweites Detektionssignal bereitzustellen, und eine zweite Detektionsschaltung (33b) zum Verarbeiten und Übertragen des ersten Detektionssignals an eine erste Schutzschaltung (34a) des erstes Gate-Puffers (1a), welche dazu eingerichtet ist, im Zuge eines Auftretens des zweiten Detektionssignals die erste Schaltvorrichtung (S_{H}) auszuschalten.

2. Gate-Treiberschaltung für eine Halbbrücke eines Konverters (100) nach Anspruch 1, wobei die erste Detektionsschaltung (33a) mit der erstes Gate-Stromspiegelungsschaltung (32a) über eine erste Isolierungsbarriere (321) verbunden ist und die zweite Detektionsschaltung (33b) mit der zweites Gate-Stromspiegelungsschaltung (32b) über eine zweite Isolierungsbarriere (322) verbunden ist.

3. Gate-Treiberschaltung für eine Halbbrücke eines Konverters (100) nach Anspruch 2, wobei die erste Isolierungsbarriere (321) und die zweite Isolierungsbarriere (322) mit Stromwandlern, Optokopplern oder Spannungswandlern hergestellt sind.

4. Gate-Treiberschaltung für eine Halbbrücke eines Konverters (100) nach den Ansprüchen 1, 2 oder 3, wobei die erste und die zweite Detektionsschaltung jeweils eine Aufbereitungsschaltung (D1, R1, C1) umfassen, um das erste und das zweite Detektionssignal zu filtern.

5. Gate-Treiberschaltung für eine Halbbrücke eines Konverters (100) nach einem der vorhergehenden Ansprüche, wobei die erste und die zweite Detektionsschaltung jeweils eine Auslöseschaltung Q2_{B}, Q2_{T} und eine falsche Detektion-Schutzschaltung (Q1_{B}, Q1_{T}, Q3_{B}, Q3_{T}) umfassen, wobei die falsche Detektion-Schutzschaltung einer aus der ersten und der zweiten Schutzschaltung die Detektion eines Überlappungsfehlers lediglich dann ermöglicht, wenn ein Detektionssignal ergeht, wenn eine positive Treiber-Befehlsausgabe (vo+) eines Vortreibers (10a, 10b) der anderen aus der ersten und der zweiten Detektionsschaltung an ist.

6. Gate-Treiberschaltung für eine Halbbrücke eines Konverters (100) nach Anspruch 5, wobei die erste und die zweite Detektionsschaltung jeweils eine Verriegelungsschaltung (331, 332) umfassen, um den detektierten überlappenden Fehler zu verriegeln, den detektierten überlappenden Fehler (Err.) an die Steuereinheit zu übertragen und die Schutzschaltung (34a, 34b) deren jeweiliger Gate-Puffer auszulösen.

7. Gate-Treiberschaltung für eine Halbbrücke eines Konverters (100) nach Anspruch 6, wobei jede aus der ersten und der zweiten Schutzschaltung (34a, 34b) aus wenigstens einem kontrollierbaren Schalter (D3ₜ, D3_{b}, Q5ₜ, Q5_{b}) bestehen, welcher eine Gate-Elektrode der entsprechenden Schaltvorrichtung (S_{H}, S_{L}) runterzieht.

8. Gate-Treiberschaltung für eine Halbbrücke eines Konverters (100) nach Anspruch 7, wobei der wenigstens eine kontrollierbare Schalter aus einer Diode und einem MOSFET hergestellt ist.

9. Gate-Treiberschaltung für eine Halbbrücke eines Konverters (100) nach Anspruch 6, wobei die Steuereinheit Zurücksetz-Ausgaben (Rs1, Rs2) zum Zurücksetzen der ersten und der zweiten Detektionsschaltung (33a, 33b) umfasst.

10. Gate-Treiberschaltung für eine Halbbrücke eines Konverters (100) nach den Ansprüchen 6 und 9, wobei die Zurücksetz-Ausgaben (Rs1, Rs2) über Isolierungsvorrichtungen (36a, 36b) verbunden sind, um Eingaben (Rst) der Verriegelungsschaltungen (331, 332) zurückzusetzen.

11. Gate-Treiberschaltung nach einem der vorhergehenden Ansprüche, wobei die Gate-Treiberpuffer (1a, 1b), welche mit den Gate-Stromspiegelungsschaltungen (32a, 32b) assoziiert sind, durch Vortreiber-Schaltungen (10a, 10b) angetrieben werden, welche Steuersignale von der Steuereinheit zu dem ersten und dem zweiten Gate-Treiberpuffer übertragen und eine galvanische Isolierung zwischen der Steuereinheit sowie dem ersten und dem zweiten Gate-Treiberpuffer bereitstellen.

12. Konverter, welcher wenigstens eine Halbbrücke aufweist, welche Gate-Treiberschaltungen nach einem der vorhergehenden Ansprüche umfasst.

## Revendications

1. Circuit d'attaque de portes pour un demi-pont d'un convertisseur (100), où un premier dispositif de commutation (S_{H}), doté d'une première porte, et un second dispositif de commutation (S_{L}), doté d'une seconde porte, sont commandés de manière complémentaire respectivement par le biais d'un premier tampon d'attaque de porte (1a) et d'un second tampon d'attaque de porte (1b), par un dispositif de commande (60) fournissant des signaux d'impulsion d'excursion haute de porte et d'excursion basse de porte aux premier et second tampons d'attaque de porte, dans lequel ledit circuit d'attaque de porte comprend un circuit de protection par chevauchement comprenant :
- sur une branche source dudit premier tampon d'attaque de porte (1a), un premier circuit de mise en miroir de courant de porte (32a) pour fournir un premier signal de détection lors de l'activation dudit premier tampon d'attaque de porte, ainsi qu'un premier circuit de détection (33a) pour traiter et transférer ledit premier signal de détection vers un second circuit de protection (34b) dudit second tampon d'attaque de porte (1b), configuré pour désactiver ledit second dispositif de commutation (S_{L}) lors de l'occurrence dudit premier signal de détection ;
- sur une branche source dudit second tampon d'attaque de porte (1b), un second circuit de mise en miroir de courant de porte (32b) pour fournir un second signal de détection lors de l'activation dudit second tampon d'attaque de porte et un second circuit de détection (33b) pour traiter et transférer ledit premier signal de détection vers un premier circuit de protection (34a) dudit premier tampon d'attaque de porte (1a) configuré pour désactiver ledit premier dispositif de commutation (S_{H}) lors de l'occurrence dudit second signal de détection.

2. Circuit d'attaque de portes pour un demi-pont d'un convertisseur (100) selon la revendication 1, dans lequel ledit premier circuit de détection (33a) est connecté audit premier circuit de mise en miroir de porte (32a) à travers une première barrière d'isolation (321) et ledit second circuit de détection (33b) est connecté audit second circuit de mise en miroir de porte (32b) à travers une second barrière d'isolation (322).

3. Circuit d'attaque de portes pour un demi-pont d'un convertisseur (100) selon la revendication 2, dans lequel ladite première barrière d'isolation (321) et ladite second barrière d'isolation (322) sont réalisées avec des transformateurs de courant, des optocoupleurs ou des transformateurs de tension.

4. Circuit d'attaque de portes pour un demi-pont d'un convertisseur (100) selon la revendication 1, 2 ou 3, dans lequel lesdits premier et second circuits de détection comprennent chacun un circuit de conditionnement (D1, R1, C1) pour filtrer les premier et second signaux de détection.

5. Circuit d'attaque de portes pour un demi-pont d'un convertisseur (100) selon l'une quelconque des revendications précédentes, dans lequel lesdits premier et second circuits de détection comprennent chacun un circuit de déclenchement Q2_{B}, Q2_{T} et un circuit de protection contre les fausses détections (Q1_{B}, Q1_{T}, Q3_{B}, Q3_{T}), ledit circuit de protection contre les fausses détections d'un desdits premier et second circuits de détection permettant la détection d'une erreur de chevauchement uniquement lorsqu'un signal de détection est émis lorsqu'une sortie de commande positive d'attaque (vo+) d'un pré-pilote (10a, 10b) de l'autre desdits premier et second circuits de détection est activée.

6. Circuit d'attaque de portes pour un demi-pont d'un convertisseur (100) selon la revendication 5, dans lequel lesdits premier et second circuits de détection comprennent chacun un circuit de verrouillage (331, 332) pour verrouiller l'erreur de chevauchement détectée, transférer l'erreur de chevauchement détectée (Err.) au dispositif de commande et déclencher le circuit de protection (34a, 34b) de leur tampon d'attaque de porte respectif.

7. Circuit d'attaque de portes pour un demi-pont d'un convertisseur (100) selon la revendication 6, dans lequel chacun desdits premier et second circuits de protection (34a, 34b) est composé d'au moins un commutateur pouvant être commandé (D3ₜ, D3_{b}, Q5ₜ, Q5_{b}) pour l'excursion basse d'une électrode de porte d'un dispositif de commutation (S_{H}, S_{L}) correspondant.

8. Circuit d'attaque de portes pour un demi-pont d'un convertisseur (100) selon la revendication 7 dans lequel ledit au moins un commutateur pouvant être commandé est constitué d'une diode et d'un MOSFET.

9. Circuit d'attaque de portes pour un demi-pont d'un convertisseur (100) selon la revendication 6, dans lequel le dispositif de commande comprend des sorties de réinitialisation (Rs1, Rs2) pour réinitialiser les premier et second circuits de détection (33a, 33b).

10. Circuit d'attaque de portes pour un demi-pont d'un convertisseur (100) selon les revendications 6 et 9, dans lequel lesdites sorties de réinitialisation (Rs1, Rs2) sont connectées à travers des dispositifs d'isolation (36a, 36b) pour réinitialiser des entrées (Rst) desdits circuits de verrouillage (331, 332).

11. Circuit d'attaque de portes selon l'une quelconque des revendications précédentes, dans lequel les tampons d'attaque de porte (1a, 1b) associés aux circuits de mise en miroir de courant (32a, 32b) sont pilotés par des circuits de pré-pilote (10a, 10b) transférant des signaux de commande du dispositif de commande aux premier et second tampons d'attaque de porte et assurant une isolation galvanique entre ledit dispositif de commande et lesdits premier et second tampons d'attaque de porte.

12. Convertisseur présentant au moins un demi-pont comprenant des circuits d'attaque de portes selon l'une quelconque des revendications précédentes.
